**Europäisches Patentamt**

**European Patent Office**

**Office européen des brevets**

(19)

(11) Veröffentlichungsnummer: **0 007 635**
**B1**

# EUROPÄISCHE PATENTSCHRIFT

(12)

(45) Veröffentlichungstag der Patentschrift:
**05.08.81**

(21) Anmeldenummer: **79102671.9**

(22) Anmeldetag: **26.07.79**

(51) Int. Cl.³: **F 21 K 2/00**, G 02 F 1/13

(54) **Vorrichtung zur Sammlung von Licht und Herstellungsverfahren für eine solche Vorrichtung.**

(30) Priorität: **02.08.78 DE 2833934**

(43) Veröffentlichungstag der Anmeldung:
**06.02.80 Patentblatt 80/3**

(45) Bekanntmachung des Hinweises auf die Patenterteilung:
**05.08.81 Patentblatt 81/31**

(84) Benannte Vertragsstaaten:
**AT CH FR GB IT NL SE**

(56) Entgegenhaltungen:
**FR-A-2 404 347**
**GB-A-1 386 714**
**GB-A-2 003 290**
**COMPUTER DESIGN, Vol. 16, Nr. 10,**
**Oktober 1977**
**«Fluorescence activated LCD$_5$**
**may serve in low light conditions»,**
**Seiten 34; 38**
**ELECTRONICS, Vol. 50, Nr. 25,**
**Dezember 1977,**
**M. BECHTLER et al.: «Dim light is**
**no turnoff for fluorescence activated LCD»,**
**Seiten 113–116**
**ELEKTRONIK, Vol. 26, Nr. 6, Juni 1977,**
**W. GREUBEL et al.: «Fluoreszenz-**
**Aktivierte Display FLAD», Seite 55–56**

(73) Patentinhaber: **SIEMENS AKTIENGESELLSCHAFT Berlin**
**und München, Postfach 22 02 61, D-8000 München 22 (DE)**

(72) Erfinder: **Greubel, Waldemar, Dipl.-Phys.,**
**Johanneskirchnerstrasse 25, D-8000 München 81 (DE)**
Erfinder: **Quella, Ferdinand, Dr.,Dipl.-Ing.,**
**Drygalski-Allee 118, D-8000 München 71 (DE)**

Vorrichtung zur Sammlung von Licht und Herstellungsverfahren für eine solche Vorrichtung

Die Erfindung betrifft eine Vorrichtung gemäss dem Oberbegriff des Anspruchs 1. Ein solcher Kollektor ist bereits in mehreren Ausführungen bekannt und kann besipielsweise zum Einfangen von Sonnenenergie, (P.W. Mauer und G.T. Turechek, Research Disclosure 29 (1975) 20, DE-A- 26 20 115 oder A. Götzberger und W. Greubel, Appl. Phys. 14 (1977) 123), zur optischen Übertragung von Nachrichten (DE-A-27 42 899), zur Bildaufhellung passiver Displays (DE-A-25 54 226 oder W. Greubel und G. Baur, Electronik 6 (1977) 55) oder zur Erhöhung der Empfindlichkeit von Szintillatoren (G. Keil, Nucl. Instr. and Meth. 87 (1970)111) verwendet werden.

Trifft Licht auf eine Fluoreszenzplatte, so wird der im Anregunsspektrum des Fluoreszenzstoffes liegende Anteil von den Fluoreszenzzentren absorbiert; der übrige Lichtanteil durchsetzt die Fluoreszenzplatten ungestört. Die absorbierte Strahlung wird – zu längeren Wellenlängen hin verschoben und räumlich ungerichtet – reemittiert. Von diesem Fluoreszenzlicht wird der weit überwiegende Teil durch (Total)-Reflexionen an den Plattengrenzflächen im Inneren der Trägerplatte fortgeleitet, bis er an bestimmten Auskoppelbereichen mit erhöhter Intensität austritt.

Die bisher mit Fluoreszenzplatten erzielten Wirkungsgrade bleiben noch immer deutlich hinter den theoretisch möglichen Werten zurück, und zwar vor allem deshalb, weil das Emissionsspektrum mit dem Absorptionsspektrum überlappt und daher die Fluoreszenzstrahlung der Platte eine endliche Absorptionslänge hat. Besonders unbefriedigend ist dabei, dass sich diese «Selbstabsorption» gerade bei Fluoreszenzkörpern mit grosser Sammelfläche besonders ungünstig auswirkt.

Man weiss bereits seit längerem, dass bei vielen organischen Fluoreszenzstoffen das Emissionsband gegenüber dem Anregungsband zu niedrigeren Frequenzen hin verschoben wird, wenn diese Farbstoffe in einer Flüssigkeit mit einer starken Orientierungspolarisation gelöst werden. Eine solche Rotverschiebung tritt auf, wenn das fluoreszierende Molekül in seinem Grund- und Anregungszustand verschiedene Dipolmomente hat und wenn sich die Umgebung, die während des Absorptionsprozesses unverändert bleibt, während der Existenz des Anregungszustandes umorientieren kann (E. Lippert, Z. Elektrochem. Ber. Bunsenges. phys. Chem. 61 (1957) 962).

Fluoreszenzkörper sollen jedoch nach Möglichkeit aus einem festen Trägermaterial bestehen. Denn feste Träger kann man, insb. wenn es organische Kunststoffe sind, mit relativ geringem Aufwand herstellen und verarbeiten, ein Vorzug, der insbesondere bei Massenfertigungen stark ins Gewicht fällt.

Dass auch in Festkörper-Lösungen die erwünschte Bandtrennung von der Dielektrizitätskonstanten des Lösungsmittels abhängt und hierbei eine wichtige Rolle spielen, wird bereits in der zitierten Arbeit von Götzberger und Greubel erwähnt (vergl. den dortigen Abschn. 3.3.). Weiterführende Untersuchungen der angedeuteten Zusammenhänge, denen sich entnehmen liesse, wie man Kunststoffe mit den erforderlichen Polarisationseigenschaften verwirklichen könnte, stehen allerdings noch aus. Vor allem aber fehlt es an Hinweisen, wie zu verfahren ist, damit die polaren Kunststoffe auch die an Fluoreszenzkörper zu stellenden Forderungen erfüllen. Ein Fluoreszenzkörper muss bekanntlich hochtransparent und thermisch wie fotochemisch stabil sein, sollte sich einfach in beliebige Formen bringen lassen, hat im Endzustand hart und formbeständig zu sein und sollte eine hohe Fluoreszenz-Quantenausbeute haben.

Aufgabe der vorliegenden Erfindung ist es, einen Fluoreszenzkörper anzugeben, der im Vergleich zu den bisher entwickelten Versionen eine deutlich geringere Selbstabsorption bei ansonsten ähnlich guten Eigenschaften hat. Diese Aufgabe wird erfindungsgemäss durch die im Patentanspruch 1 angegebene Vorrichtung gelöst.

Die Erfindung geht aus von der Überlegung, dass die gesuchte Rotverschiebung auch schon dann auftreten müsste, wenn nur die unmittelbaren Nachbar-Moleküle der einzelnen Fluoreszenz-Moleküle polar und beweglich sind. Eine solche Struktur liesse sich realisieren, wenn es polare Flüssigkeiten gibt, die um jedes Fluoreszenzzentrum spontan eine Hülle bilden und sich ihrerseits in dem Trägermedium so einbetten lassen, dass eine feste Emulsion entsteht. Ein solches Dispersionssystem hätte den besonderen Vorteil, dass man mit geringen Zusatzmengen auskommt und somit praktisch keine Verträglichkeitsprobleme entstehen.

Bei flüssigen Lösungen kennt man das Phänomen, dass amphiphile Moleküle, also Moleküle mit einem hydrophilen (polaren) und einem lipophilen (unpolaren) Ende, in einem nur hydrophilen oder nur lipophilen Medium charakteristische Kolloide, sog. Mizellen bilden (vergl. hierzu beispielsweise Winsor, Chem. Rev. 68 (1968) 1). Diese charakteristischen Teilchen werden durch Nebenvalenzen, Kohäsionskräfte oder van der Waals-Kräfte zusammengehalten und sind in bestimmten Temperatur- und Konzentrationsbereichen stabil, wenn sich das System im thermodynamischen Gleichgewicht befindet. Bekannteste Beispiele sind die wässrigen Seifenlösungen. Hier sind die polaren Enden der Seifen-Moleküle den Wasser-Molekülen zugewandt, während die unpolaren Enden der Seifen-Moleküle in das Innere der Mizelle weisen.

Versuche im Zusammenhang mit der Erfindung haben gezeigt, dass sich erstens bei Zugabe eines Fluoreszenzstoffes in eine solche mizelläre Lösung die einzelnen Fluoreszenz-Moleküle jeweils mit einer Mizellen-Hülle umgeben. Zweitens stellte sich heraus, dass diese Mizellen auch in organische Kunststoffe eingebracht werden können, wobei der Flüssigkeitscharakter dieser Kolloide erhalten bleibt.

Amphiphile Verbindungen haben vielfach keine besonders ausgeprägte Polarität. In diesen Fällen kann man noch ein hochpolares Lösungsmittel für den Fluoreszenzstoff hinzufügen, das die Mizellen-Bildung nicht behindert und zusammen mit dem Fluoreszenz-Molekül umhüllt wird.

Weitere vorteilhafte Ausgestaltungen und Weiterbildungen der Erfindung sind Gegenstand zusätzlicher Ansprüche.

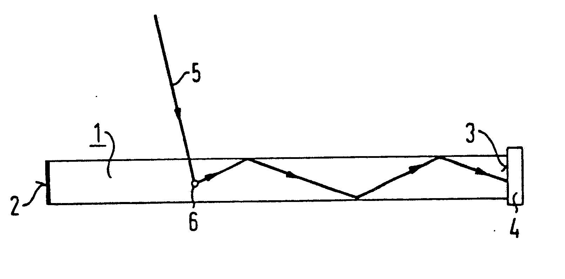

Der Lösungsvorschlag soll nun anhand eines bevorzugten Ausführungsbeispiels in Verbindung mit der beigefügten Figur näher erläutert werden.

Die Figur stellt in einem etwas schematisierten Seitenschnitt eine Lichtsammelvorrichtung dar, die als Sonnenkollektor verwendet werden kann. Diese Vorrichtung enthält im einzelnen eine Fluoreszenzplatte 1, die an drei ihrer vier Schmalseiten jeweils mit einer Reflexionsschicht 2 versehen ist und an ihrer vierten Schmalseite (Lichtaustrittsseite 3) eine Solarzelle 4 trägt. In der Figur ist der typische Weg eines im Anregungsspektrum der fluoreszierenden Partikel liegenden Sonnenstrahls eingezeichnet: Der mit 5 bezeichnete Strahl wird von einem Fluoreszenzzentrum 6 im Inneren der Fluoreszenzplatte 1 absorbiert, reemittiert und mittels Totalreflexion durch die Lichtaustrittsseite 3 auf die Solarzelle 4 geführt.

Als Amphiphile kommen vor allem Seifen in Frage. Dabei eignen sich neben den gewöhnlichen Seifen auch polymere Seifen. Andere geeignete Amphiphile sind beispielsweise Polyvinylpyrrolidon oder Polymethacrylsäure und deren Salze. Solche Amphiphile schaffen dem Fluoreszenzfarbstoff ebenfalls eine polare Umgebung, sie machen ein polares Lösungsmittel in bestimmten Fällen überflüssig.

Folgende organische Kunststoffe sollten zweckmässigerweise verwendet werden: Polyacrylate und -methacrylate, Polystyrole, ebenso Copolymere mit Methacrylaten und Styrolen als Hauptkomponenten.

Der Fluoreszenzkörper lässt sich folgendermassen am rationellsten herstellen:

Der – ggf. in einem polaren Lösungsmittel wie z.B. hochsiedende Alkohole gelöste – Fluoreszenzstoff wird zusammen mit einem amphiphilen Zusatz in den Kunststoff-Träger eingemischt. Während des Mischvorganges muss der Kunststoff flüssig sein und dürfen bestimmte Temperaturen, die etwa bei 100°C liegen, nicht überschritten werden, da sonst die Mizellen zerstört werden. Die Mischung wird dann in die endgültige Körperform gebracht und anschliessend nach bekannten Verfahren durch Polymerisation bzw. Vernetzung gehärtet.

Der flüssige Kunststoff kann als Monomer (Beispiel: Methylmethacrylat), als unvernetztes Polymer (Beispiel: ungesättigte Polyesterharze) oder in vorpolymerisierter Form vorliegen. Die eingemischten Additive, also der amphiphile Zusatz darf ggf. ein polares Lösungsmittel, haben normalerweise einen Gewichtsanteil an der Gesamtmasse von 1 bis etwa 10 Gew. %.

Die Gestaltung der endgültigen Körperform erfolgt am besten in einer Giesstechnik, da hier die niedrigsten Temperaturen auftreten.

Da die Fluoreszenzfarbstoffe üblicherweise sehr oxydationsempfindlich sind, empfiehlt es sich, als Polymerisations-Initiatoren nichtoxidierend wirkende Substanzen zu nehmen. Ein solcher Initiator kann aus der Reihe der Tetraphenyläthane, deren bekanntester Vertreter Benzpinakol ist, stammen. Sofern als Einbettungsmaterial ein Giessharz (ein ungesättigtes Polyesterharz), bei dem sich die gleichen amphiphilen Zusätze wie z.B. Polyoxyäthylensorbitanmonolaurat verwenden lassen, eingesetzt wird, sind wiederum nichtoxidierende Initiatoren zur Vernetzung anzuwenden.

Die Erfindung ist nicht auf das dargestellte Ausführungsbeispiel beschränkt. Insb. kann der Fluoreszenzkörper auch anders als plattenartig gestaltet sein, wenn nur dafür gesorgt ist, dass er aufgrund von Totalreflexionen als Lichtfalle wirken kann. Eine Reihe günstiger Körpergestaltungen sind in der DE-A-27 24 748 angegeben. Ferner sei darauf hingewiesen, dass der Begriff «Kolloid» im vorliegenden Zusammenhang nicht in seiner engen Definition verwendet wird, die bekanntlich bestimmte Teilchengrössen vorschreibt. Der gewählte Mizellendurchmesser hängt von einer Reihe von Randbedingungen ab und muss deutlich kleiner als eine Lichtwellenlänge sein, damit keine Lichtstreuung an den Mizellen erfolgt.

15 Patentansprüche
1 Figur

## Patentansprüche

1. Vorrichtung zur Sammlung von Licht, mit einem als Lichtfalle wirkenden, vorzugsweise plattenförmig ausgebildeten Körper («Fluoreszenzkörper»), der aus einem Kunststoff-Träger mit einem Brechungsindex grösser 1 besteht, fluoreszierende Partikel enthält und mit mindestens einem Lichtaustrittsfenster versehen ist, dadurch gekennzeichnet, dass die fluoreszierenden Partikel ein Dipolmoment mit unterschiedlichen Werten im Grundzustand und im Anregungszustand haben und dass im Kunststoff-Träger ein amphiphiler Zusatz kolloidal gelöst ist, derart, dass die fluoreszierenden Partikel jeweils von einem der Kolloid-Teilchen umschlossen sind und sich im Kolloid-Teilchen in einer Umgebung mit einer Orientierungspolarisation befinden, wobei sich die Umgebung derart rasch umorientieren kann, dass sie während der Existenz des Anregungszustandes des fluoreszierenden Partikels praktisch vollständig ihr thermodynamisches Gleichgewicht erreicht.

2. Vorrichtung nach Anspruch 1, dadurch gekennzeichnet, dass der Zusatz eine polare Substanz ist.

3. Vorrichtung nach Anspruch 1 oder 2, dadurch gekennzeichnet, dass in den einzelnen Kolloid-Teilchen jeweils noch ein polares Lösungsmittel für das fluoreszierende Partikel eingeschlossen ist.

4. Vorrichtung nach Anspruch 3, dadurch gekennzeichnet, dass das polare Lösungsmittel ein hochsiedender Alkohol, insbesondere ein Glykol, ist.

5. Vorrichtung nach einem der Ansprüche 1 bis 4, dadurch gekennzeichnet, dass der amphiphile Zusatz eine Seife, vorzugsweise eine polymere Seife, insbesondere ein Polyäthylensorbitanmonolaurat ist.

6. Vorrichtung nach einem der Ansprüche 1 bis 4, dadurch gekennzeichnet, dass der amphiphile Zusatz aus Polyvinylpyrrolidon oder Polymethacrylsäure und deren Salzen besteht.

7. Vorrichtung nach einem der Ansprüche 1 bis 6, dadurch gekennzeichnet, dass der Kunststoff-Träger polymerisiert ist.

8. Vorrichtung nach Anspruch 7, dadurch gekennzeichnet, dass der Kunststoff-Träger ein Polyacrylat, ein Polymethacrylat oder ein Polystyrol ist.

9. Vorrichtung nach Anspruch 7, dadurch gekennzeichnet, dass der Kunststoff-Träger ein Copolymer mit einem Methacrylat und einem Styrol als Hauptkomponenten ist.

10. Vorrichtung nach einem der Ansprüche 7 bis 9, dadurch gekennzeichnet, dass der Kunststoff-Träger einen nichtoxidierenden Polymerisations- und/oder Vernetzungs-Initiator hat.

11. Vorrichtung nach Anspruch 10, dadurch gekennzeichnet, dass der Initiator ein Tetraphenyläthan, insbesondere ein Benzpinakol, ist.

12. Vorrichtung nach einem der Ansprüche 1 bis 11, dadurch gekennzeichnet, dass der Anteil des Zusatzes und ggf. des polaren Lösungsmittels zwischen 1 und 10 Gew. %, bezogen auf die Gesamtmasse des Fluoreszenzkörpers, liegt.

13. Verfahren zur Herstellung einer Vorrichtung nach einem der Ansprüche 1 bis 12, dadurch gekennzeichnet, dass der Fluoreszenzstoff, ggf. gelöst in einem polaren Lösungsmittel, und der amphiphile Zusatz in den in flüssiger Form vorliegenden Kunststoff-Träger eingemischt werden und dass anschliessend diese Mischung in die endgültige Körperform gebracht und dann verfestigt wird.

14. Verfahren nach Anspruch 15, dadurch gekennzeichnet, dass der Kunststoff beim Einmischungsvorgang als Monomer, als unvernetztes Polymer oder in vorpolymerisierter Form vorliegt.

15. Verfahren nach Anspruch 14, dadurch gekennzeichnet, dass die Mischung in die endgültige Körperform gegossen und anschliessend durch Polymerisation bzw. Vernetzung gehärtet wird.

**Claims**

1. Apparatus for collecting light having a preferably plate-shaped body («Fluorescence body») acting as a light-trap, which consists of a carrier of plastics material having a refractive index greater than 1, containing fluorescent particles and provided with at least one light emergence window, characterised in that the fluorescent particles have a dipole moment having different values in the ground state and in the excited state, and in that, in the plastics carrier there is colloidally dissolved an amphiphilic additive in such manner that each of the fluorescent particles is enclosed by one of the colloid particles, and is present in the colloid particle in an environment which has an orientating polarisation, the environment being able to re-orientate itself so rapidly that it virtually completely reaches its thermodynamic equilibrium during the lifetime of the excitation state of the fluorescent particles.

2. Apparatus as claimed in Claim 1, characterised in that the additive is a polar substance.

3. Apparatus as claimed in Claim 1 or Claim 2, characterised in that a polar solvent for the fluorescent particle is enclosed in each colloid particle.

4. Apparatus as claimed in Claim 3, characterised in that the polar solvent is a high-boiling point alcohol, in particular a glycol.

5. Apparatus as claimed in one of Claims 1 to 4, characterised in that the amphiphilic additive is a soap, preferably a polymeric soap, in particular a polyethylenesorbitan monolaurate.

6. Apparatus as claimed in one of Claims 1 to 4, characterised in that the amphiphilic additive is polyvinyl pyrrolidone, or plymethacrylic acid and its salts.

7. Apparatus as claimed in one of Claims 1 to 6, characterised in that the plastics material of the carrier is polymerized.

8. Apparatus as claimed in Claim 7, characterised in that the plastics carrier is made of a polyacrylate, a polymethacrylate, or a polystyrene.

9. Apparatus as claimed in Claim 7, characterised in that the plastics carrier is made of a copolymer having a methacrylate and a styrene as principal components.

10. Apparatus as claimed in one of Claims 7 to 9, characterised in that the plastics carrier has a non-oxidising polymerization initiator and/or cross-linking initiator.

11. Apparatus as claimed in Claim 10, characterised in that the initiator is a tetraphenylethane, in particular, a benzopinacol.

12. Apparatus as claimed in one of Claims 1 to 11, characterised in that the proportion of the additive, and of the polar solvent when present, is in the range of between 1 and 10% by weight with reference to the total weight of the fluorescence body.

13. A process for the production of apparatus as claimed in one of Claims 1 to 12, characterised in that the fluorescent material, possibly dissolved in a polar solvent, and the amphiphilic additive are mixed with the plastics material of the carrier which is present in liquid form, and that this mixture is subsequently brought into the final shape of the body and then solidified.

14. A process as claimed in Claim 13, characterised in that in the mixing process, the plastics material is present as monomer, as an un-cross-linked polymer, or in a pre-polymerized form.

15. A process as claimed in Claim 14, characterised in that the mixture is cast into the final body shape and is subsequently hardened by polymerization and/or cross-linking.

**Revendications**

1) Dispositif destiné à collecter de la lumière, comprenant un corps («corps fluorescent»), servant de piège à lumière et ayant de préférence la forme d'une plaque, qui est en un support en matière plastique ayant un indice de réfraction supérieur à 1, qui renferme des particules fluorescentes et qui présente au moins une lucarne de sortie pour la lumière, caractérisé en ce que les particules fluorescentes ont un moment dipolaire de valeur différente à l'état fondamental et à l'état excité, et dans le support en matière plastique est dissous colloïdalement un additif amphiphile de manière à ce que les particules fluorescentes soient entourées par l'une des particules colloïdales et se trouvent dans les particules colloïdales dans un entourage ayant une polarisation d'orientation, cet entourage pouvant être réorienté rapidement de manière à ce que, pendant l'existence de l'état excité, la particule fluorescente atteigne pratiquement entièrement son équilibre thermodynamique.

2) Dispositif suivant la revendication 1, caractérisé en ce que l'additif est une substance polaire.

3) Dispositif suivant la revendication 1 ou 2, caractérisé en ce que dans les particules colloïdales est enfermé aussi un solvant polaire de la particule fluorescente.

4) Dispositif suivant la revendication 3, caractérisé en ce que le solvant polaire est un alcool à point d'ébullition élevé, notammen un glycol.

5) Dispositif suivant l'une des revendications 1 à 4, caractérisé en ce que l'additif amphiphile est un savon, de préférence un savon polymère, notamment un monolaurate de polyéthylènesorbitan.

6) Dispositif suivant l'une des revendications 1 à 4, caractérisé en ce que l'additif amphiphile est constitué de polyvinylpyrrolidone, d'acide polyméthacrylique ou de leurs sels.

7) Dispositif suivant l'une des revendications 1 à 6, caractérisé en ce que le support en matière plastique est polymérisé.

8) Dispositif suivant la revendication 7, caractérisé en ce que le support en matière plastique est un polyacrylate, un polyméthacrylate ou un polystyrène.

9) Dispositif suivant la revendication 7, caractérisé en ce que le support en matière plastique est un copolymère ayant un méthacrylate et un styrène comme constituants principaux.

10) Dispositif suivant l'une des revendications 7 à 9, caractérisé en ce que le support en matière plastique a un initiateur de polymérisation et/ou de réticulation qui n'est pas oxydant.

11) Dispositif suivant la revendication 10, caractérisé en ce que l'initiateur est un tétraphényléthane, notamment un benzospinacol.

12) Dispositif suivant l'une des revendications 1 à 11, caractérisé en ce que l'additif et, le cas échéant, le solvant polaire représentent de 1 à 10% du poids total du corps fluorescent.

13) Procédé de fabrication d'un dispositif suivant l'une des revendications 1 à 12, caractérisé en ce qu'il consiste à mélanger la matière fluorescente, le cas échéant dissoute dans un solvant polaire, et l'additif amphiphile au support en matière plastique se présentant sous forme liquide, puis à mettre ce mélange sous la forme finale du corps et à le solidifier.

14) Procédé suivant la revendication 13, caractérisé en ce que la matière plastique lors du mélange se présente sous la forme d'un monomère, d'un polymère non réticulé ou d'un prépolymère.

15) Procédé suivant la revendication 14, caractérisé en ce qu'il consiste à couler le mélange sous la forme finale du corps et ensuite à le durcir par polymérisation ou par réticulation.